# EUROPEAN PATENT APPLICATION

(11) **EP 2 508 546 A1**
(43) Date of publication of application: **10.10.2012**
(21) Application number: 10834542.2
(22) Date of filing: 30.11.2010
(51) Int. Cl.: C08G 59/70, C08G 59/50, H01L 23/29, H01L 23/31

(54) **EPOXY RESIN COMPOSITION**

(30) Priority: 01.12.2009 JP 2009273807
(71) Applicant: Nagase ChemteX Corporation, Osaka-shi, Osaka 550-8668 (JP)
(72) Inventor: MIZUIKE, Katsuyuki, Tatsuno-shi Hyogo 679-4124 (JP); ISOBE, Tomoki, Tatsuno-shi Hyogo 679-4124 (JP); SHINOHARA, Makoto, Santa Clarita, California 91350 (US)
(74) Representative: Vossius & Partner
(86) International application number: PCT/JP2010/071321
(87) International publication number: WO 2011/068092

(57) **Abstract**

A low temperature curable epoxy resin composition which comprises: an epoxy component that contains an epoxy compound having per molecule at least two epoxy groups and that is liquid at 25°C; an aromatic amine based curing agent that contains an aromatic amine compound having per molecule at least two amino groups directly bonded to the aromatic ring and that is liquid at 25°C; andMg(II) acetylacetonate as a cure accelerator. The composition, which contains a novel cure accelerator using a metal complex, exhibits high stability at room temperature while lowering a cure temperature or shortening a cure time.

## Description

### TECHNICAL FIELD

The present invention relates to an aromatic amine-curable epoxy resin composition containing a cure accelerator and capable of being cured at low temperature in a short time.

### BACKGROUND ART

Epoxy resin compositions containing epoxy compounds and aromatic amine curing agents exhibit strong adhesion to various surfaces after the thermal cure thereof and also are superior in mechanical, physical, and electrical characteristics, and chemical bonds formed by the cure thereof are more chemically and thermally stable than chemical bonds formed by the cure of widely used acid anhydride-curable epoxy resin compositions. Moreover, such compositions have a special advantage that the glass transition points of cured products can be varied widely and mechanical, physical, and electrical characteristics can be controlled by varying the mole ratio of epoxy groups to amino groups, and the compositions can be used widely as a binder of adhesives, fillers, coating materials, composites, encapsulants, impregnants, sealants, and the like.

However, conventional aromatic amine-curable epoxy resin compositions have fatal drawbacks of needing prolonged cure at high temperatures of 150°C or higher due to their slow cure. Such a high-temperature prolonged curing process reduces productivity while consuming a great deal of energy. Thermal cure at high temperature narrows the range of applications of aromatic amine-curable epoxy resin compositions, increases the thermal stress of cured products, and impairs the reliability and durability of products produced using such compositions.

Heretofore, there has been attempted development of a cure accelerator with which stability at room temperature can be obtained while lowering the cure temperature or shortening the cure time of aromatic amine-curable epoxy resin compositions. For example, Patent Document 1 has disclosed that inorganic acid salts of metals such as Na, K, Ca, Al, Sr, Mn, Ba, Zn, and Fe, accelerate the thermal cure of an epoxy compound with an amine compound. However, since the inorganic acid salts will cause corrosion of metal and fall of product reliability due to such corrosion, applications of such epoxy resin compositions are limited. Further, Patent Document 2 has disclosed that carboxylates of metals such as Li, Na, Ca, Zn, Ba, Cu, Co, Ni, Mn, Cr, and Mg promote the thermal cure of epoxy resins by amine curing agents.

On the other hand, as to metal complexes, Patent Document 3 has disclosed an effect that a complex of Co(III) with acetylacetone promotes the cure of a composition of an epoxy compound with an aromatic amine based curing agent and improves mechanical characteristics of a cured product. In Examples, there has been disclosed that using this complex, a composition comprising a bisphenol A epoxy resin and diamino-diphenyl sulfone is cured at 140 to 150°C for about 2 hours and then at 175 to 204°C for 2 to 4 hours, to obtain improved characteristics. Patent Document 4 has disclosed that Co(III) acetylacetonate promotes the cure of a composition comprising an epoxy compound and an aromatic amine. For the cure of the composition comprising an epoxy compound and an aromatic amine, a condition of 150°C/2 hours has been used.

Patent Document 5 has disclosed that π-electron acceptors are effective to reduce the peak temperature of an exothermic cure reaction measured by a differential scanning calorimeter (hereinafter DSC) during the cure of a composition comprising an epoxy compound and an aromatic amine. The composition comprising an epoxy compound and an aromatic amine includes a commonly known epoxy resin and a primary or secondary amine. Examples of the π-electron acceptor include tetraphenylborates of heterocyclic compounds containing nitrogen or sulfur, complexes such as ferrocinium tetrachloroferrate, Cu(II) trifluoroacetylacetonate, and acetylacetonates of Co(II), Co(III), Mn(II) and Mn(III). In one of Examples, it has been disclosed that if Cu(II) trifluoroacetylacetonate is added to a composition comprising an epoxy compound and an aromatic amine , including a bisphenol F epoxy resin and 9,9-bis(3-chloro-4-aminophenyl)fluorene, the peak temperature of an exothermic reaction measured by DSC falls by 46°C compared with the absence of catalysts. However, Examples of other acetylacetonates, i.e., acetylacetonate of Co(II), Co(III), Mn(II), or Mn(III) have not been disclosed.

Moreover, in Patent Documents 6, 7, and 8, a cure accelerator using a compound containing nitrogen and a transition metal complex in combination is used in a composition comprising an epoxy resin and a secondary amine. Although acetylacetonates of Pt(TI), Co(II), Co(III), Ni(II), Cu(II), Fe(II), Fe(III), Cr(II), Cr(III), Mn(II), and Mn(III) are disclosed as transition metal complexes, only acetylacetonates of Co(II) and Co(III) are used in combination with 1-cyanoethyl-2-ethyl-4-methylimidazole in Examples.

It should be noted that the metal complexes whose catalytic effect has been proved concretely in these documents are of a transition element or a Group 13 element. On the other hand, storage stability at low temperature often fails to be secured by only possession of a cure acceleration effect. Therefore, cure accelerators by which stability at room temperature is obtained while a cure temperature is lowered or a cure time is shortened, particularly, a novel cure accelerator using a metal complex has been demanded.

### PRIOR ART DCCUMENTS

### PATENT DOCUMENTS

Patent Document 1: USP 3,492,269
Patent Document 2: USP 4,115,296
Patent Document 3: USP 4,473,674
Patent Document 4: JP-A 2000-103838
Patent Document 5: USP 5,541,000
Patent Document 6: USP 6,617,399
Patent Document 7: USP 6,670,430
Patent Document 8: USP 6,951,907

### SUMMARY OF THE INVENTION

### PROBLEMS TO BE SOLVED BY THE INVENTION

The present invention provides an epoxy resin composition using a novel cure accelerator using a metal complex in order to solve such problems regarding aromatic amine-curable epoxy resin compositions. Particularly, it provides an aromatic amine-curable epoxy resin composition by which stability of a composition at room temperature is obtained while a cure temperature is lowered or a cure time is shortened.

### MEANS FOR SOLVING THE PROBLEMS

The present invention is a low temperature curable epoxy resin composition, comprising an epoxy component that contains an epoxy compound having per molecule at least two epoxy groups and that is liquid at 25°C; an aromatic amine based curing agent that contains an aromatic amine compound having per molecule at least two amine groups directly bonded to the aromatic ring and that is liquid at 25°C; and Mg (II) acetylacetonate as a cure accelerator. The fact that Mg(II) acetylacetonate is effective as a cure accelerator for epoxy resin compositions using an amine curing agent and moreover the compositions possess stability at room temperature is a novel finding obtained by the present inventors. The epoxy resin composition of the present invention is invented based on the discovery of new properties regarding such Mg(II) acetylacetonate. Accordingly, use of Mg(II) acetylacetonate, which is a known compound, as a cure accelerator for a curing reaction between an epoxy compound and an aromatic amine based curing agent has also been invented by the present inventors.
In the epoxy resin composition of the present invention, at least one compound selected from the group consisting of Mn(II) acetylacetonate and Co(III) acetylacetonate can be further contained as a cure accelerator. Although such acetylacetonates are known to be used as a cure accelerator for epoxy resin compositions using amine curing agents, a composition using such a curing agent in combination with Mg (II) acetylacetonate is provided in the present invention.
In the epoxy resin composition of the present invention, a cure accelerator is blended in an amount of 0.1 to 15 parts by weight, more restrictively 0.4 to 10 parts by weight, based on 100 parts by weight of the epoxy component.
The present invention further provides an epoxy resin composition for encapsulating electronic components, the composition comprising the epoxy resin composition of the invention as an essential ingredient.
The present invention further provides an electronic component encapsulated using the epoxy resin composition for encapsulating electronic components.

### EFFECTS OF THE INVENTION

In the epoxy component to be used in the present invention, one or two or more epoxy compounds having per molecule at least two epoxy groups are used. The amine curing agent to be used in the present invention includes one or two or more aromatic amine compounds having per molecule at least two amino groups attached directly to an aromatic ring. The curing reaction of a composition of such an epoxy compound with such an aromatic amine is very slow without use of a suitable cure accelerator and realization of a stable thermal cure state by a sufficient crosslinking reaction needs cure performed under the cure conditions of a high temperature of 150°C or higher and a time of several hours or longer. Conversely, the present invention can be used for products whose maximum use temperature is 125°C or lower (e.g., electronic components) and thus applications of compositions of an epoxy compound with an aromatic amine will be extended.

Cure at low temperature is very effective for reducing the thermal stress of cured products, and it is more desirable if objectives can be attained without lowering the glass transition point. If the epoxy resin composition of the present invention is cured at 125°C, the thermal stress will be reduced to about 2/3 according to estimation based on warpage compared with a product prepared by curing a conventional composition of an epoxy compound with an aromatic amine at 160°C though both are comparable to each other with respect to glass transition point. Cure at low temperature or a shortened cure time suppresses consumption of energy during the curing step, and increases productivity and reduces thermal stress, and therefore it is possible to increase the reliability and durability of products to be produced using the composition.

Metal complex salts and complexes serve as a cure accelerator and will provide cured products of epoxy resin compositions superior in physical, chemical, mechanical, and electrical characteristics. Metal acetylacetone complexes provide cured products with further superior characteristics. However, the metal acetylacetone complexes that have heretofore been used are complexes with transition metal or heavy metal. In recent years, use of transition metals and heavy metals, such as chromium, nickel, and cobalt, had been restricted with consideration for environment, health, and hygiene and, for this reason, development of cure accelerators with consideration for environment, health, and hygiene have been an important subject. In contrast, the present invention provides an epoxy-aromatic amine composition using a magnesium-acetylacetone complex that is environmental friendly, low in toxicity, and easy to obtain, as a cure accelerator.

### MODE FOR CARRYING OUT THE INVENTION

The epoxy resin composition of the present invention includes at least three components: (a) an epoxy component that contains an epoxy compound having per molecule at least two epoxy groups and that is liquid at 25°C, (b) an aromatic amine based curing agent that has per molecule at least two amino groups attached directly to an aromatic ring and that is liquid at 25°C, and (c) Mg(II) acetylacetonate as a cure accelerator. The state of being liquid at 25°C means a state having flowability at 25°C, and the range of the degree of flowability is wide. Generally, the flowability which should be exhibited as a one-component epoxy resin composition serves as a guideline. While the degree of flowability is appropriately selected according to the purpose of use and is not limited, preferably, for example, the viscosity measured with an E type viscometer is 10 Pa·s or less.

The epoxy component (a) in the epoxy resin composition of the present invention is liquid at 25°C and contains an epoxy compound having per molecule at least two epoxy groups. The above-mentioned epoxy component (a) maybe (1) an epoxy compound (a-1) that is liquid at 25°C and has per molecule at least two epoxy groups, (2) an epoxy compound (a-3) that is solid at 25°C and has per molecule at least two epoxy groups, which is liquefied with a reactive diluent (a-2) that is liquid at 25°C and has per molecule one epoxy group, or (3) an epoxy compound (a-3) that is solid at 25°C and has per molecule at least two epoxy groups, which is liquefied with the epoxy compound (a-1) that is liquid at 25°C and has per molecule at least two epoxy groups. Among these, the above-described (1) is preferred.

In order to be good workability or to adjust various characteristics, the reactive diluent (a-2) having an epoxy group may be used in combination with the epoxy compound of the above-described (1) or (3). In this case, the amount of the reactive diluent (a-2) used may be determined appropriately according to objectives such as workability.

The above-described epoxy compound (a-1) and epoxy compound (a-3) are compounds in which the number of epoxy groups contained in a molecule is two or more in view of the fact that a crosslinked structure capable of exhibiting sufficient heat resistance can be formed, or the like. Moreover, compounds with four or fewer epoxy groups are preferred and compounds with three or fewer epoxy groups are more preferred in view of the fact that a resin composition with low viscosity can be obtained, or the like. If the number of the epoxy groups contained in a molecule is too small, cured products may easily tend to become low in heat resistance or low in strength, whereas if the number is too large, the resin composition may easily tend to become high in viscosity or large in cure shrinkage.

The number average molecular weight of the above-mentioned epoxy compound (a-1) that is liquid at 25°C is preferably 230 to 440, and more preferably 230 to 380 in view of the fact that a resin composition with low viscosity can be obtained, a balance between physical properties is good, or the like. If the number average molecular weight is too small, cured products may easily tend to become low in strength or moisture resistance, whereas if it is too large, the resin composition may easily tend to become high in viscosity.

The weight per epoxy equivalent of the above-mentioned epoxy compound (a-1) is preferably 50 to 500, and more preferably 90 to 300 in view of the fact that the amount of the curing agent blended falls within a proper range, or the like.

The number average molecular weight of the above-mentioned epoxy compound (a-3) that is solid at 25°C is preferably 150 to 6,000, and more preferably 180 to 1,600 in view of the fact that a resin composition with low viscosity can be obtained, a balance between physical properties is good, or the like.

The weight per epoxy equivalent of the above-mentioned epoxy compound (a-3) is preferably 75 to 3,000, and more preferably 90 to 800 in view of the fact that the amount of the curing agent blended falls within a proper range, or the like.

As the above-mentioned epoxy compound (a-1), commonly known liquid epoxy resins can be used. Examples thereof include bisphenol A, bisphenol F, bisphenol AD, dihydroxynaphthalene, aminophenol, polyalkylene diol, polyalkylene glycol, and epoxy resins obtained by epoxidation of modified bodies thereof, alicyclic epoxy resins and mixtures thereof which are liquid at 25°C. Among these, a bisphenol A epoxy resin, a bisphenol F' epoxy resin, a bisphenol AD epoxy resin, a naphthalene type epoxy resin, an epoxy resin obtained by epoxidation of aminophenol (glycidyl aminophenol type epoxy resin), and the like are preferred in view of the fact that they are relatively low in viscosity, they are superior in heat resistance and moisture resistance, or the like. Mixture of such epoxy compounds may also be used.

The above-mentioned epoxy compound (a-3) is selected from among commonly known epoxy resins such as a dicyclopentadiene type epoxy resin, a biphenyl type epoxy resin, a phenol novolac type epoxy resin, an o-cresol novolac type epoxy resin, and a silicone-modified epoxy resin, mixtures thereof, and modified bodies thereof, that are solid at 25°C. Use of the epoxy compound (a-3) makes it possible to control the glass transition point and various physical properties and characteristics of a cured epoxy resin product.

In the case where the above-mentioned epoxy compound (a-3) is used in addition to the above-mentioned epoxy compound (a-1), although the blended proportion thereof is not particularly limited as far as the mixture is in a liquefied form, from the viewpoint of liquefaction of the mixture, for example, the ratio of the epoxy compound (a-3) to the total of the epoxy compound (a-1) and the epoxy compound (a-3) is preferably 1 to 50% by weight, and more preferably 3 to 30% by weight.

As the above-mentioned reactive diluent (a-2), a commonly known reactive diluent that is liquid at 25°C and has per molecule one epoxy group can be used. Examples thereof include tert-butylphenyl glycidyl ether, 2-ethylhexyl glycidyl ether, allyl glycidyl ether, and phenyl glycidyl ether. These may be used singly or two or more of them may be used in combination.

In the above-mentioned epoxy component (a), other epoxy compounds can be used according to need for adjustment of the viscosity of the composition, the modulus of elasticity of a cured product or the like. Examples of the other epoxy compound include hydroxy group-containing alkylene glycidyl ethers such as hydroquinone diglycidyl ether, 2,5-di-tert-butylhydroquinone diglycidyl ether, butanediol diglycidyl ether, butenediol diglycidyl ether, butynediol diglycidyl ether, glycerine triglycidyl ether, trimethylolpropane triglycidyl ether, and pentaerythritol tetraglycidyl ether; glycidyl group-containing hydantoin compounds such as 1,3-diglycidyl-5,5-dialkylhydantoin and 1-glycidyl-3-(glycidoxyalkyl)-5,5-dialkylhydantoin; glycidyl esters such as diglycidyl phthalate, diglycidyl tetrahydrophthalate, and dimer acid diglycidyl ester; glycidyl group-containing amino compounds such as tetraglycidyl diaminodiphenylmethane, triglycidyl-p-aminophenylmethane, triglycidyl-m-aminophenylmethane, diglycidylaniline, diglycidyltoluidine, and tetraglycidyl-m-xylylenediamine; glycidyl group-containing siloxanes such as 1,3-bis(3-glycidoxypropyl)-1,1,3,3-tetramethyldisiloxane and α,ω-bis(3-glycidoxypropyl)polydimethylsiloxane. These may be used singly or two or more of them may be used in combination.

It is preferred to adjust the content of the above-mentioned reactive diluent (a-2) or the above-mentioned other epoxy compounds to 30% by weight or less, and more preferably 15% by weight or less in the epoxy component (a) in view of the moisture resistance or heat resistance of a cured product.

The aromatic amine curing agent (b) in the epoxy resin composition of the present invention contains an aromatic amine compound having per molecule at least two amino groups attached directly to an aromatic ring and that is liquid at 25°C. The above-mentioned aromatic amine curing agent (b) is (1) an aromatic amine (b-1) that is liquid at 25°C and has per molecule at least two amino groups attached directly to an aromatic ring, or (2) an aromatic amine based curing agent (b-3) obtained by dissolving an aromatic amine (b-2) that is solid at 25°C and has per molecule at least two amino groups attached directly to an aromatic ring in the above-mentioned aromatic amine (b-1) that is liquid at 25°C, and liquefying the resultant. The above-described (1) is preferred.

In order to enable formation of a crosslinked structure capable of exhibiting sufficient heat resistance, the above-mentioned aromatic amine (b-1) and aromatic amine (b-2) shall have per molecule two or more amino groups. Aromatic amines with four or fewer amino groups are preferred and aromatic amines with three or fewer amino groups are more preferred in view of the fact that a resin composition with low viscosity can be obtained, or the like. If the number of the amino groups contained in a molecule is too small, a cured product tends to become low in heat resistance or to become low in strength, whereas if it is too large, a resin composition tends to become high in viscosity or to become large in cure shrinkage.

Liquid alkyl polyamine and liquid aralkyl polyamine are too reactive and often degrade stability at room temperature, and, for this reason, are not used in the present invention.

Examples of the aromatic amine (b-1) include diethyldiaminotoluene, bis(4-amino-3-ethylphenyl)methane, and polytetramethylene oxide-di-p-aminobenzoate. Among these, diethyldiaminotoluene and bis(4-amino-3-ethylphenyl)methane are preferred.

Examples of the aromatic amine (b-2) that is solid at 25°C include compounds represented by the following general formula (1) and compounds represented by the following general formula (2) :

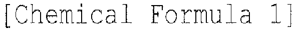

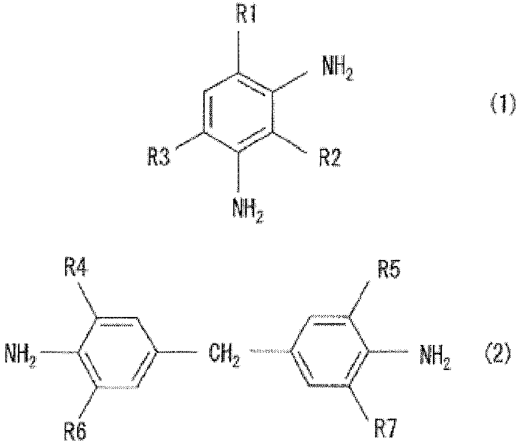

wherein, R1 through R7 each independently represent an alkyl group with 1 to 4 carbon atoms (e.g., methyl, ethyl, n-propyl, i-propyl, n-butyl, i-butyl, sec-butyl, and tert-butyl).

Specific examples of such compounds include tetramethyldiaminodiphenylmethane, tetraethyldiaminodiphenylmethane, diethyldimethyldiaminodiphenylmethane, dimethyldiaminotoluene, diaminodibutyltoluene, and diaminodipropyltoluene.

The above-mentioned aromatic amine (b-2) may be other aromatic amines besides the compounds represented by the general formula (1) given above and the compounds represented by the general formula (2) given above. Examples of the other aromatic amine include diaminodiphenylsulfone and diaminoditolylsulfone.

In the case where the above-mentioned aromatic amine (b-2) that is solid at 25°C and the aromatic amine (b-1) that is liquid at 25°C are used, although the blended proportion thereof is not particularly limited as far as the resulting aromatic amine curing agent (b-3) is in a liquefied form, from the viewpoint of liquefaction of the mixture, for example, the ratio of the aromatic amine (b-1) to the total of the aromatic amine (b-1) and the aromatic amine (b-2) is preferably 40 to 99% by weight, and more preferably 70 to 99% by weight. In the case where the above-mentioned other aromatic amine is used as the aromatic amine (b-2), it is preferred to adjust the content thereof to 30% by weight or less, and more preferably 15% by weight or less in the aromatic amine curing agent (b) in view of the moisture resistance or heat resistance of a cured product.

The amount of the aromatic amine curing agent (b) in the epoxy resin composition of the present invention, which varies according to an application or a glass transition point required, is preferred to be blended so that the number of the active hydrogen atoms of amino groups per mol of epoxy groups may become 0.6 to 2.0 mol. If the aromatic amine curing agent (b) is blended so that the number of the active hydrogen atoms of amino groups per mol of epoxy groups may become 0.9 to 1.1 mol, a cured product will exhibit a high glass transition point.

The cure accelerator (c) in the epoxy resin composition of the present invention is Mg(II) acetylacetonate. The Mg(II) acetylacetonate may be either an anhydride or a hydrate. The acetylacetonate complex is a compound represented by the following general formula (3):

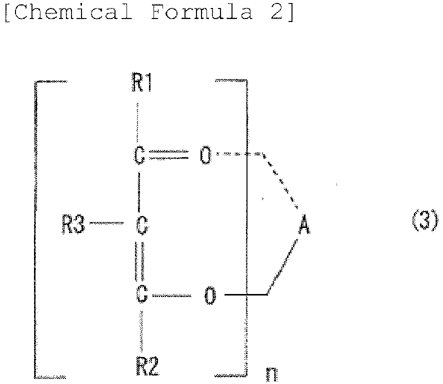

wherein, R1 and R2 each independently represent a hydrocarbon group with 1 to 20 carbon atoms that may have a halogen substituent, such as alkyl, aryl, or halogenated alkyl, specifically methyl, ethyl, propyl, halides thereof, such as mono-, di-, or tri-fluoromethyl. R3 is a hydrogen atom or a hydrocarbon group with 1 to 20 carbon atoms that may have a halogen substituent, and specifically, such as hydrogen or methyl. n is an integer of 1 or more and up to the valence of ligand A. A is a metal such as Co, Mn, Mg, or Na.

In Mg(II) acetylacetonate, A in the above formula (3) is Mg. As Mg(II) acetylacetonate, a compound in which R1 and R2 are methyl, R3 is a hydrogen atom, and n is 2 is preferably used. Mg is an element that exists in a relatively large amount on the earth or in sea water and can be obtained easily, and is less toxic than heavy metals and friendly to environment.

In the present invention, metal acetylacetonates other than Mg(II) acetylacetonate or other known cure accelerators may be used in combination as part of the cure accelerator (c) in order to adjust the characteristics of the epoxy resin composition before and after curing. Examples of the other metal acetylacetonates include at least one compound among Mn(II) acetylacetonate, Co(III) acetylacetonate, Zn(II) acetylacetonate, and Ni(II) acetylacetonate, and Mn(II) acetylacetonate and Co(III) acetylacetonate are preferred.

In the case where at least one compound among Mn(II) acetylacetonate, Co(III) acetylacetonate, Zn(II) acetylacetonate, and Ni(II) acetylacetonate is used, the amount thereof to be blended is preferably 100% by weight or less, and more preferably 50% by weight or less based on Mg(II) acetylacetonate.

In order to obtain a required curing rate and room temperature stability, the amount of the cure accelerator (c) blended in the epoxy resin composition of the present invention is preferably 0.1 to 15 parts by weight, and more preferably 0.4 to 10 parts by weight based on 100 parts by weight of the epoxy component (a). Also in the case where a metal acetylacetonate other than Mg(II) acetylacetonate is used, the total amount including Mg(II) acetylacetonate preferably falls within this range.

In order to produce the epoxy resin composition of the present invention, prescribed amounts of the epoxy component (a) and the aromatic amine curing agent (b) may be stirred and dispersed together with the cure accelerator (c) to form a one-component epoxy resin composition with flowability at room temperature (in the present specification, room temperature refers to 25°C). As occasion demands, it is also permitted that, for example, the cure accelerator (c) is put aside for blending it at the time of use, thereby forming a two-component epoxy resin composition. Moreover, by adding various commonly known additives (e.g., defoamer, surfactant, colorant, adhesion promoter, and ion getter), modifiers (e.g., stress absorber, reactive diluent, and thixotropic agent), fillers (e.g., silica filler, fiber glass, carbon fiber, and other inorganic fillers), and the like to be used in the related products field, the epoxy resin composition of the present invention can afford a liquefied epoxy resin composition having workability and physical properties suitable for applications such as adhesive, filler, coating agent, composite, encapsulant, impregnant, and sealant and the like. It may be diluted with a solvent and used. Therefore, liquefied epoxy resin compositions suitable for applications such as adhesive, filler, coating agent, composite, encapsulant, impregnant, sealant and the like obtained by adding various commonly known additives, modifiers and fillers and the like to the epoxy resin composition of the present invention, and highly reliable and durable products obtained by using such liquefied epoxy resin compositions are both within the scope of the present invention. Examples thereof include epoxy resin compositions for electronic component encapsulation containing the epoxy resin composition of the present invention as an essential ingredient and, according to need, also containing additives, electronic components encapsulated therewith, such as semiconductors, capacitors, and noise filters, and coils.

The present invention will be described more specifically by way of Examples or the like, however, the present invention is not limited thereto.

### Examples 1 to 5, Comparative Examples 1 to 4

Examples 1 to 5 and Comparative Examples 1 to 4 aim to verify the cure acceleration effect of Mg(II) acetylacetonate (compound represented by the above formula (3) wherein R1 and R2 are methyl groups, R3 is a hydrogen atom, and n is 2; this was applied to Examples and Comparative Examples) by means of combinations of two epoxy compounds (bisphenol F (expressed as BisF in the table) and bisphenol A (expressed as BisA in the table) and two aromatic amine curing agents (diethyldiaminotoluene (expressed as EKW in the table) and bis(4-amino-3-ethylphenyl)methane) (expressed as KHAA in the table). Comparative Examples 1 to 4 are systems without any cure accelerator, whereas 3 parts by weight of Mg(II) acetylacetonate (expressed as Mg (II) AcAc in the table) was used in Example 1 and 3 parts by weight of Mg(II) acetylacetonate hydrate (expressed as Mg(II)AcAc·2H₂O in the table) was used in Examples 2 to 5. The compositions of Examples 1 to 5 and Comparative Examples 1 to 4 are shown in Table 1 given below. Each amount to be blended is expressed in part(s) by weight. Respective components were mixed to thereby prepare respective compositions.

The bisphenol F epoxy compound used was EXA-830LVP (average weight per epoxy equivalent: 161; viscosity at 25°C: 2 Pa·s) produced by DIC Corporation, the bisphenol A epoxy compound was LX-01 (average weight per epoxy equivalent: 178; viscosity at 25°C: 7.5 Pa·s) produced by DAISO Co., Ltd., the EKW was diethyldiaminotoluene produced by Japan Epoxy Resin Corporation (average amine value: 631 KOHmg/g; viscosity at 25°C: 0.3 Pa·s), the KHAA was bis (4-amino-3-ethylphenyl)methane (KAYAHARD A-A; viscosity at 25°C: 2 Pa·s) produced by Nippon Kayaku Co., Ltd., the Ng(II)AcAc was from Strem Chemical, and the Mg(II)AcAc·2H₂O was from Aldrich Chemical Co., both being reagent grade.

**[Table 1]**

| | | Example 1 | Example 2 | Example 3 | Example 4 | Example 5 | Comparative Example 1 | Comparative Example 2 | Comparative Example 3 | Comparative Example 4 |
|---|---|---|---|---|---|---|---|---|---|---|
| BisF | | 100 | 100 | 100 | - | - | 00 | 100 | - | - |
| BisA | | - | | - | 100 | 100 | - | - | 100 | 100 |
| EKW | | 30 | 30 | - | 27 | - | 30 | - | 27 | - |
| KHAA | | - | - | 39 | - | 36 | - | 39 | - | 36 |
| Mg (II) AcAc | | 3 | - | - | - | - | - | | - | - |
| Mg (II) AcAc 2H₂O | | - | 3 | 3 | 3 | 3 | - | - | - | - |
| Stability | | 2.3 | 2.0 | 1.4 | 1.5 | 1.4 | 1.3 | .2 | 1.1 | 1.1 |
| Acceleratability | 125°C | 6.3 | 7.9 | 7.5 | 10.0 | 9.5 | 1.0 | 1.0 | 1.0 | 1.0 |
| | 160°C | 9.3 | 7.9 | 6.5 | 10.3 | 7.4 | 1.3 | 1.0 | 1.0 | 1.0 |
| Gel time (second) | 125°C | 770 | 610 | 377 | 560 | 340 | 4830 | 2810 | 5630 | 3270 |
| | 160°C | 130 | 155 | 104 | 133 | 114 | 1220 | 680 | 1373 | 840 |
| Tg (°C) | | 136 | 142 | 114 | 170 | 136 | 109 | 16 | 126 | 138 |

### Evaluation methods

Stability: For each composition, the viscosity at room temperature immediately after the preparation thereof and the viscosity at room temperature after being left hermetically at room temperature for 24 hours were measured with E-Type Viscometer, and then a value calculated by dividing the viscosity of the composition left at room temperature for 24 hours by the initial viscosity was expressed as stability in the table. The lower this value is, the slower a reaction at room temperature is and stability and workability at room temperature are held better.
Acceleratability, gel time: Gelation times of respective compositions at 125°C and 160°C were determined with Sunshine Gel Meter. For each system, a value calculated by dividing the gelation time of a composition free of a cure accelerator by the gelation time of a composition with addition of a cure accelerator at the same temperature was expressed as acceleratability. The higher this value is, the greater the cure acceleration effect is.
Glass transition point (Tg) : Glass transition point was measured with DSC manufactured by Mettler under the condition of 16°C/minute using a sample thermally cured at 160°C for 90 minutes.

The results shown in Table 1 show that by the addition of 3 parts by weight of Mg(II) acetylacetonate, the gelation time was shortened remarkably and the curing reaction was accelerated remarkably. Moreover, it is shown that even though Mg(II) acetylacetonate was added, stability was maintained and superior storage stability was obtained. The stability at room temperature of the system in which KHAA was employed as a curing agent was better than the system in which EKW was employed. Furthermore, the difference in effect between the anhydride of Mg(II) acetylacetonate and the hydrate thereof was small.

### Examples 6 to 12

There are given in Table 2 the measured results of the stability and acceleratability of the epoxy resin compositions obtained by blending 100 parts by weight of EXA-830LVP (expressed as BisF in the table), 30 parts by weight of EKW, and widely varied amounts of Mg(II) acetylacetonate added as a cure accelerator, and 1g of cured products after cure at 160°C for 90 minutes. The evaluation methods used are the same as those of Examples 1 to 5.

**[Table 2]**

| | | Example 6 | Example 7 | Example 8 | Example 9 | Example 10 | Example 11 | Example 12 |
|---|---|---|---|---|---|---|---|---|
| Bisb | | 100 | 100 | 100 | 100 | 100 | 100 | 100 |
| EKW | | 30 | 30 | 30 | 30 | 30 | 30 | 30 |
| Mg (II) AcAc | | 0.1 | 0.4 | 1 | 3 | 5 | 10 | 15 |
| Stability | | 1.3 | 1.6 | 1.9 | 2.3 | 4.1 | 6.6 | 8.5 |
| Acceleratability | 125°C | 1.7 | 3.3 | 5.4 | 6.3 | 8.0 | 8.2 | 8.8 |
| | 160°C | 1.5 | 3.1 | 4.8 | 9.3 | 7.0 | 7.6 | 7.1 |
| Tg (°C) | | 138 | 140 | 142 | 136 | 143 | 144 | 142 |

The results given in Table 2 show that a cure acceleration effect was revealed by addition of Mg(II) acetylacetonate even in only a small amount as much as 0.1 parts by weight and stability was observed up to 15 parts by weight. A preferable amount to be added is considered to be between 0.4 and 10 parts by weight.

### Examples 13 to 15

Mn(III) acetylacetonate (expressed as Mn(AcAc)3 in the table), Mn(II) acetylacetonate (expressed as Mn(AcAc)2 in the table), and Co (III) acetylacetonate (expressed as Co(AcAc)3 in the table) were used as a cure accelerator together with Mg(II) acetylacetonate (expressed as Mg(AcAc)2 in the table). The stability, acceleratability, and Tg of the epoxy resin composition including 100 parts by weight of EXA-83CLVP (expressed as BisF in the table) and 30 parts by weight of EKW were measured in the same manner as in Examples 1 to 5. The results are shown in Table 3.

**[Table 3]**

| | | Example 13 | | Example 14 | | Example 15 | |
|---|---|---|---|---|---|---|---|
| BisF | | 100 | | 100 | | 100 | |
| EKW | | 30 | | 30 | | 30 | |
| Care accelerator (part by weight) | | Mg (AcAc)2 | Mn (AcAc)3 | Mg (AcAc)2 | Mn (AcAc)2 | Mg (AcAc)2 | Co (AcAc)3 |
| | | 2.5 | 0.5 | 2.6 | 0.5 | 2.0 | 2.0 |
| Stability | | 6.0 | | 3.3 | | 2.8 | |
| Acceleratability | 125°C | 8.9 | | 7.6 | | 9.6 | |
| | 160°C | 6.3 | | 6.3 | | 6.5 | |
| Tg (°C) | | 143 | | 141 | | 142 | |

As shown by the results given in Table 3, it is possible to employ Mg(II) acetylacetonate as a main cure accelerator and also employ acetylacetonates of other metals in combination.

### Example 16, Comparative Examples 5 to 12

Comparative Examples in which Mn(II) acetylacetonate (expressed as Mn(AcAc)2 in the table), Co(III) acetylacetonate (expressed as Co(AcAc)3 3 in the table), Zn(II) acetylacetonate (expressed as Zn(AcAc)2 in the table), Fe(II) acetylacetonate (expressed as Fe(AcAc)2 in the table), Cr(III) acetylacetonate (expressed as Cr(AcAc)3 in the table), Co(II) acetylacetonate (expressed as Co(AcAc)2 in the table), and Mn(III) acetylacetonate (expressed as Mn(AcAc) 3 in the table) were used as a cure accelerator were compared with Example in which Mg(II) acetylacetonate dihydrate (expressed as Mg(AcAc)2·2H₂O in the table). It is noted that no cure accelerator was used in Comparative Example 5. The stability, acceleratability, and Tg of the epoxy resin composition including 100 parts by weight of bisphenol A (expressed as BisA in the table) and 26 parts by weight of EKW were measured in the same manner as in Examples 1 to 5, respectively. The results are shown in Table 4.

**[Table 4]**

| | | Example 16 | Comparative Example 5 | Comparative Example 6 | Comparative Example 7 | Comparative example 8 | Comparative Example 9 | Comparative Example 10 | Comparative Example 11 | Comparative Example 12 |
|---|---|---|---|---|---|---|---|---|---|---|
| BisA | | 100 | 100 | 100 | 100 | 100 | 100 | 100 | 100 | 100 |
| EKW | | 26 | 26 | 26 | 26 | 26 | 26 | 26 | 26 | 26 |
| Cure accelerator (part by weight) | | Mg (AcAc)2·2 H₂O | - | Mn (AcAc)2 | Co (AcAc)3 | Zn (AcAc) 2 | Fe (AcAc)2 | Cr (AcAc)3 | Co (AcAc)2 | Mn (AcAc) 3 |
| | | 3.0 | - | 3.0 | 3.0 | 3.0 | 3.0 | 3.3 | 3.0 | 3.0 |
| Stability | | 1.5 | 1.1 | 1.8 | 1.4 | 3.6 | 2.4 | 1.2 | ∞ | ∞ |
| Acceleratability | 125°C | 10.0 | 1.0 | 5.3 | 6.7 | 3.6 | 1.6 | 1.1 | 5.0 | 10.8 |
| | 160°C | 10.3 | 1.0 | 8.3 | 5.7 | 3.0 | 1.5 | 1.2 | 5.1 | 7.0 |
| Tg (°C) | | 170 | 126 | 174 | 171 | 168 | 131 | 141 | 173 | 174 |

As shown by the results given in Table 4, the case where Mg(II) acetylacetonate was used as a cure accelerator was superior in stability and remarkably superior in acceleratability compared with acetylacetonates of other metals. In comparison with the case where Mn(II) acetylacetonate was used alone as a cure accelerator (Comparative Example 6) and the case where Co(III) acetylacetonate was used alone as a cure accelerator (Comparative Example 7), although the stability was similar, the acceleratability was greatly different and therefore the superiority of Mg(II) acetylacetonate was apparent. Mn(III) acetylacetonate (Comparative Example 12) was unstable though it was high in acceleratability.

### Examples 17 to 18, Comparative Examples 13 to 15

Comparative Example 13 is an epoxy-aromatic amine composition that includes 100 parts by weight of a bisphenol F epoxy resin (henceforth expressed as BisF) and 30 parts by weight of diethyldiaminotoluene (henceforth expressed as EKW) and contains no cure accelerator, and Examples 17, 18, Comparative Examples 14, 15 are epoxy-aromatic amine compositions each containing 3 parts by weight of an acetylacetonate of alkali or alkaline earth group metal given in the table as a cure accelerator, each having been prepared by fully dispersing and stirring those ingredients.

The bisphenol F epoxy compound used was EXA-830LVP (average weight per epoxy equivalent: 161; viscosity at 25°C: 2 Pa·s) produced by DIC Corporation, the EKW was diethyldiaminotoluene produced by Japan Epoxy Resin Corporation (average amine value: 631 KOHmg/g; viscosity at 25°C: 0.3 Pa·s), the Mg(II) acetylacetonate, Mg(II) acetylacetonate hydrate, and Ca(II) acetylacetonate were from Aldrich Chemical Co., all being reagent grade, and Na(I) acetylacetonate was reagent grade from Strem Chemical.

**[Table 5]**

| | | Example 17 | Example 18 | Comparative Example 13 | Comparative Example 14 | Comparative Example 15 |
|---|---|---|---|---|---|---|
| Cure accelerator (part by weight) | | Mg (AcAc) 2 | Mg (AcAc) 2·2H₂O | - | Na (AcAc)·H₂O | Ca (AcAc)2 |
| | | 3.0 | 3.0 | - | 3.0 | 3.0 |
| Stability | | 2.3 | 2.0 | 1.2 | 1.3 | 1.7 |
| Acceleratability | 125°C | 6.3 | 7.8 | 1.0 | 1.5 | 1.9 |
| | 160°C | 9.3 | 8.1 | 1.0 | 1.0 | 2.0 |
| Tg (°C) | | 136 | 143 | 109 | 113 | 130 |

As shown in Table 5, it is shown that by the addition of 3 parts by weight of Mg(II) acetylacetonate, the gelation time was shortened remarkably and the curing reaction was accelerated remarkably. On the other hand, Ca(II) acetylacetonate and Na (I) acetylacetonate exhibit a small cure acceleration effect. Moreover, it is shown that even though Mg(II) acetylacetonate was added, stability was maintained and superior storage stability was obtained. Furthermore, the difference in effect between the anhydride of Mg(II) acetylacetonate and the hydrate thereof was small.

## Claims

1. A low temperature curable epoxy resin composition, comprising:
an epoxy component that contains an epoxy compound having per molecule at least two epoxy groups and that is liquid at 25°C;
an aromatic amine based curing agent that contains an aromatic amine compound having per molecule at least two amino groups directly bonded to the aromatic ring and that is liquid at 25°C; and
Mg(II) acetylacetonate as a cure accelerator.

2. The epoxy resin composition according to claim 1, wherein the epoxy compound is at least one compound selected from the group consisting of a bisphenol A epoxy compound, a bisphenol F epoxy compound, a bisphenol AD epoxy compound, a naphthalene type epoxy compound, and a glycidylaminophenol type epoxy resin.

3. The epoxy resin composition according to claim 1 or 2, wherein the aromatic amine compound is at least one compound selected from the group consisting of diethyldiaminotoluene and bis(4-amino-3-ethylphenyl)methane.

4. The epoxy resin composition according to any one of claims 1 to 3, further comprising at least one compound selected from the group consisting of Mn(II) acetylacetonate, Co(III) acetylacetonate, Zn(II) acetylacetonate, and Ni(II) acetylacetonate as a cure accelerator.

5. The epoxy resin composition according to any one of claims 1 to 4, wherein the cure accelerator is contained in an amount of 0.1 to 15 parts by weight based on 100 parts by weight of the epoxy component.

6. The epoxy resin composition according to claim 5, wherein the cure accelerator is contained in an amount of 0.4 to 10 parts by weight based on 100 parts by weight of the epoxy component.

7. An epoxy resin composition for encapsulating electronic components, the composition comprising the epoxy resin composition according to any one of claims 1 to 6 as an essential ingredient.

8. An electronic component encapsulated using the epoxy resin composition for encapsulating electronic components according to claim 7.
